Europäisches Patentamt

European Patent Office

Office européen des brevets

(11) Publication number: **0 196 408**
**A1**

(12) **EUROPEAN PATENT APPLICATION**

(21) Application number: **86100686.4**

(22) Date of filing: **20.01.86**

(51) Int. Cl.⁴: **G 06 F 15/20**
**G 01 R 21/00**

(30) Priority: **03.04.85 ES 542007**

(43) Date of publication of application:
**08.10.86 Bulletin 86/41**

(84) Designated Contracting States:
**AT BE CH DE FR GB IT LI LU NL SE**

(71) Applicant: **Empresa Nacional de Electricidad, S.A.**
**Principe de Vergara, 187**
**E-28002 Madrid(ES)**

(71) Applicant: **ELIOP, S.A.**
**Maria Lombillo, 14**
**E-28027 Madrid(ES)**

(72) Inventor: **Macias Yanez, Manuel**
**Principe de Vergara, 187**
**E-28002 Madrid(ES)**

(72) Inventor: **Fernandez Peragon, José-Vincente**
**Maria Lombillo, 14**
**E-28027 Madrid(ES)**

(74) Representative: **Lehn, Werner, Dipl.-Ing. et al,**
**Hoffmann, Eitle & Partner Patentanwälte Arabellastrasse**
**4 (Sternhaus)**
**D-8000 München 81(DE)**

(54) Energy counter measuring system.

(57) An energy counter measuring system which enables the transition balance of energy generated by electric centrals and energy distribution systems to be obtained, offering information both on a local level as well as in a centralized station communicated via a communications channel with a plurality of remote stations, and generating the detection of the energy supplied by each electric central or the like from pulse sensors-generators, comprises a plurality of counter equipment, each of which is capable of receiving information from a further plurality of pulse sensors-generators, with variable pulse/energy conversion coefficients and an identification code of the respective sensor-generator, each equipment incorporating a clock-calendar (19) for local registration, a printer (6) for emitting written information, a non-volatile memory unit (3), a local screen-keyboard console (4, 5), and a local magnetic recording device; each remote equipment having access, via a communications channel, to a concentration station provided with a communications interface for each channel, an interface for pheripheral elements and an interface for the energy management centralized station; and the various equipments being provided with electrical auto-protecting and alarm generating means, all configured as a brached-type radial communications network.

./...

FIG.1

- 1 -

Energy Counter Measuring System                    0196408

The present invention refers to an energy counter measuring system.

Currently for the energy transition balance, heat centrals and distribution systems are normally equipped with EPC's (Energy Pulse Counters) which totalize the energy produced by each group of these centrals or the energy transmitted by each distribution line.

The object of the invention is to proportion novel equipments to replace current EPC's, which comply with current normatives, thereby generating a completely automatized and centralized energy control system.

The system of the invention employs the said EPC's, that is to say, pulse sensors-generators which communicate with a series of microprocessor-based autonomous stations, configured in such a manner that they can be interconnected via a communications channel to form a branched-type radial network.

At the apex of this hierarchical pyramid of the network, there is a multiplexor assembly which enables the measurements of the different remote terminals to be made in a centralized manner, configured so as to be compatible with currently employed energy control systems or with any other alternative management means.

Further, this invention proportions the ability of equipping a concentrator with a module for automatically calling the switched network of a particular distribution company (for example that of Empresa Nacional de Electricidad, S.A.), including the detection of tones and enabling linking to the remote terminals via the existing network.

In this manner, and as already indicated, with the present invention it will be possible to locally become aware of the energy transition balance at the different stations and centrals, and to also become aware of the balance of a plurality of branched points at a concentration point.

The features for solving the object of the invention appear from the claims.

The invention will be better understood from the following description taken in conjunction with the accompanying drawings in which, illustratively but not limiting:

Figure 1 is a block diagram of the internal architecture of an energy counter terminal, in accordance with the invention.

Figure 2 is a block diagram of the internal architecture of the terminal concentrator station.

Figure 3 is the structure of the EPC (energy pulse counter) devices.

Figure 4 is the basic functional organisation of a counter register, connected or not to the RTU, with the option of individual remote register.

Figure 5 is a variation of a counter acquisition autonomous network, connected or not to the RTU.

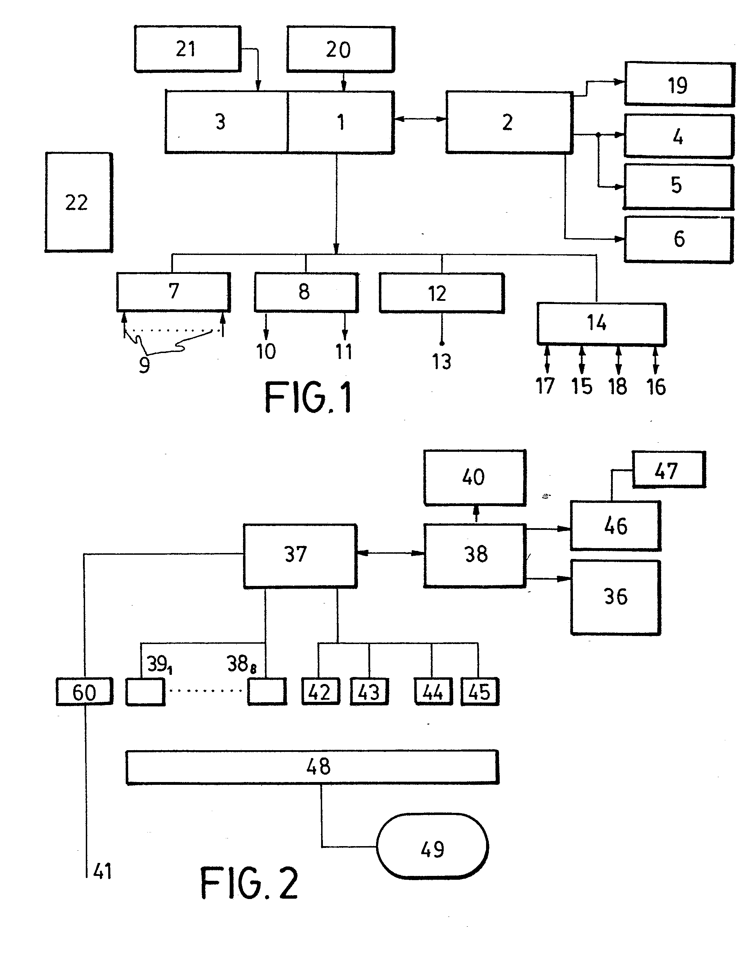

Referring to the said drawings and particularly to figure 1, it can be seen that the energy counter measuring system, in accordance with the invention, comprises a plurality of terminals, the internal structure of which is precisly shown in this figure 1. These terminals have two interconnected processors, one of which

- 3 -

0196408

is the master processor 1 and the other constitutes the slave processor 2 which is reserved to perform auxiliary tasks.

Operation of these processors is controlled by the program existing in a memory block 3.

The terminal in question has the following peripheral elements:

Operational keyboard 4 comprising both a functional as well as a numerical keyboard from which operation of the terminal is interactively programmed, and from which operational status information can be requested. This keyboard 4 has an alphabet graphics introduction process to insert "assignation headings" into the various counters.

As a support for this keyboard 4 and, in general, for displaying messages, there is provided a visual display means 5 formed of twelve electroluminescent diode type alphanumeric characters.

The twenty-character printer 6 is a device adjoining the equipment and records the initialisation program, the possible changes therein "a posteriori", and hourly reflects the different alarms managed by the system. Further, any recordal made is accompanied by the date and hour at which it is produced.

The master processor 1 is connected to an input sub-system 7 which is comprised of various cards for electrically conditioning the various signals from the pulse emitting relays, by means of which the energy counting is managed. This signal conditioning, naturally, involves the galvanic isolation of the system from the signals.

This input sub-system 7 is capable of accepting a total of 256 counter input channels.

Further, the master processor 1 controls the communications interface 8 with the RTU, which receives information from the "watch dog" device, as well as the commands for the parallel transference of the information.

As indicated, the input sub-system 7 receives the input channels 9, whereas the communications interface 8 is provided with the data and command transmitting channels 10 and 11, respectively.

A further communications interface 12 has been provided for establishing a link with the switched network via the subscriber line 13. The card 14 will establish four communication lines, preferably according to standard V.24, which is controlled by the master processor 1 of the terminal. Each of these four communication lines performs the following:

Line 15 is a connection line to a local printer, having preferably an 80-character format, which is capable of writing the hour protocols of the energy counters and those lists requested by the system operator.

Via line 16 is established a magnetic taped storage output, according to a format determined by the user, in which the energy counter data will be stored with hourly periodicities.

Line 17 consists of a connection for a standard V.24 modem enabling linking to the concentrator terminal, which will be described subsequently.

0196408

Finally, line 18 determines an output for connection to a remote register terminal into which can be connected a modem since it has a standard V.24 interface.

Block 19 consists of a quartz-driven, battery-operated clock-calendar system. The clock system starts off with the initialisation process of the system chronometrically, that is, starting takes place at a precise moment by depressing a key and it will be resynchronised with the RTU requests, if any, assuming on the contrary the hour responsibility.

It must be pointed out that the data of this clock-calendar 19 can be modified at the request of the concentrator terminal, arbitrating in this manner a remote correcting procedure of any hour shift produced over prolonged periods of time. Further, the calendar takes into account the differences in days of the months and the leap years, and is autonomous of the general supply of the equipment for a period of 15 days.

The communications interface for the switched network 12 has a circuit for detecting a call and coupling to the subscriber line 13. It further incorporates a low-velocity modem which can operate in a recut band at two kilocycles, enabling the counter data to be communicated via this line and the remote admissions from the blocks o. the repetition requests thereof, in case of error, to be received.

The organization of these terminals is completed with the block 20 comprising an assembly of real time markers, from the battery sub-system 21 and from the supply sub-system 22.

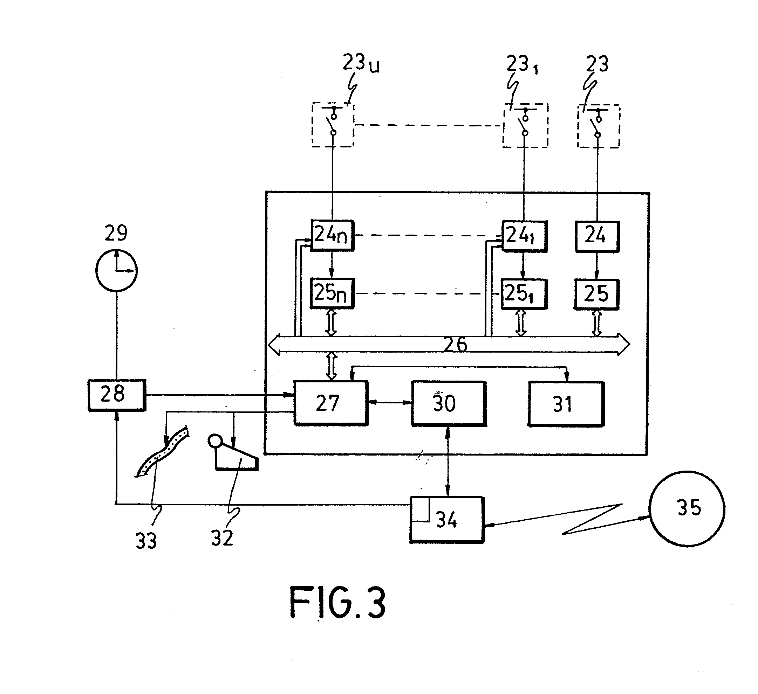

According to the above description, figure 3 shows the structure of an energy pulse counter equipment. According to this figure, a plurality of pulse generating devices $23$, $23_1$ ... $23_n$ are connected to a corresponding plurality of counters $24$, $24_1$ .. $24_n$ which, in turn, are connected to respective memories $25$, $25_1$... $25_n$. This structure is connected to a bidirectional bus 26 which transmits information to the respectic logic control 27. this logic control 27, in turn, is connected, through block 28 formed of a switching logic, to the clock device 29, to the multiplexed interface 30 and to a local console 31. A printer 32 and a magnetic tape recorder 33 are also provided in this diagram. Block 34 represents the RTU whereas block 35 represents the general oontrol centre.

Each of the described terminals, according to the preceding structure, can be connected to up to 256 simple pulse counters and 16 multiple counters. A simple counter is defined as that which has an associated input point, counting the pulses received therefrom. On the contrary, a multiple counter is defined as that which has up to 16 associated input points, adding or substracting the pulses from each of them.

According to the foregoing, the local operator of one terminal of the system could, by operating the keyboard 4, request the following information:

Actual date and hour of the internal clock.

Display of the number of pulses received up to that moment on the visual display means 5.

0196408

Display of the energy of any counter up to that moment, and its periodic renewal on the visual display means.

Printing of the two preceding paragraphs by the alarm printer 6, including the associated text heading, if any.

Isochronic listing of a block of counters, specifying the first counter of the block and the last.

Likewise, being aware of the intervention number of the keyboard, the following parametric modifications can be effected: date, hour, counter activation/deactivation, modification of the unitary weight of each of them, and modification of threshold alarms.

Figure 2 of the accompanying drawings illustrate the internal architecture of the concentrator terminal comprising a specialised communicating terminal having a functional and numerical keyboard 36 similar to that of the previously described terminal, although its functionality is adapted to the specific behaviour of this concentrator terminal.

As in the case of the energy pulse counter terminals, this concentrator terminal has a dual processor structure, comprising the master processor 37 and the slave processor 38.

This concentrator terminal has up to eight communication channels $39_1$ ... $39_8$, according to standard V.24, which permits the branched output for different physical lines and different transmission speeds, programmable by electrical bridges in their component card.

The numerical and functional keyboard 36 includes a visual display means having twelve alphanumeric characters which will serve for programming the equipments and its subsequent operation.

A printer 40 is controlled by the slave processor 38 for supporting the interactive programming and recordal of the communication alarms.

The master processor also controls an automatic dialling channel 60 compatible both with the switched telephone network as well as with a particular telephone network, admitting up to 18 dialling numbers with intermediate tone waits. Linking with the subscriber number is designated by 41.

There is also provided an output channel 42 for connection to a printer, in standard V.24. The channel 43 controls the communications in the standard V.24 SCE system, and there are also provided two standard V.24 channels 44 and 45 for other possible uses to be determined by the user.

Block 46 determines a clock-calendar system operated by the block of batteries 47.

Facing all the communication channels there is a block of modems 48 capable of being linked to eight branches of the counter system and having phonic and supraphonic band links, generically designated by block 49.

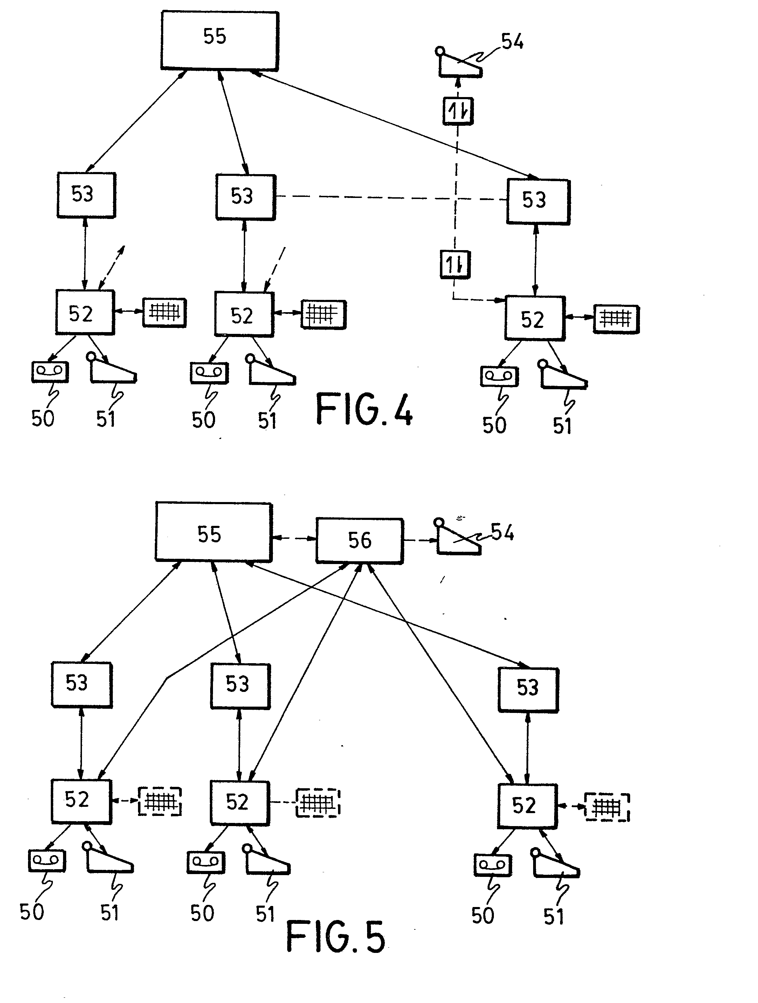

Figure 4 of the accompanying drawings illustrates the basic structure of a counter register assembly connected to the RTU or not, with option of individual remote register, in accordance with the system of the inven-

- 9 -

0196408

tion.

According to this figure 50 and 51 represent different magnetic tape recording printer units, whereas blocks 52 define the energy pulse counter terminals, according to the structure of figure 1, which are connected to the units and possibly to a remote printer 54, all being concentrated in the centralized energy control system 55.

Figure 5 is a variation of this structure including the energy pulse counter concentrator 56.

Thus, the described structure enables the energy generated by various producing centrals or supplying stations to be counted, managed and balanced, obtaining information both on a local level as well as on a centralized level, as to the measurement performed by the energy counter measuring system of the present invention.

0196408

# C L A I M S

1. Energy counter measuring system which enables the transition balance of energy generated by electric centrals and energy distribution systems to be obtained, offering information both on a local level as well as in a centralized station communicated via a communications channel with a plurality of remote stations, and generating the detection of the enery supplied by each electric central or the like from pulse sensors-generators, characterised in that it comprises a plurality of counter equipments, each of which is capable of receiving information from a further plurality of pulse sensors-generators, with variable pulse/energy conversion coefficients and an identification code of the respective sensor -generator, each equipment incorporating a clock-calendar for local registration, a printer for emitting written information, a non-volatile memory unit, a local screen- keyboard console, and a local magnetic recording device; each remote equipment having access, via a communications channel, to a concentration station provided with a communications interface for each channel, an interface for pheripheral elements and an interface for the energy management centralized station; and the various equipments being provided with electrical auto-protecting and alarm generating means, all configured as a branched-type radial communications network.

2. Energy counter measuring system according to claim 1, characterised in that each counter equipment is formed of an autonomous station comprising two processors, a master processor and a slave processor, the master processor being assisted by a real time clock, by the slave processor, and by a memory assisted by a permanent electrically fed block, the slave processor being assigned a clock-calendar block, an operational keyboard, a visual display means, and an alarm printer, and the master processor managing the signals received from a block for receiving inputs from the pulse sensors-generators, a communications interface with the RTU, a communications interface via a switched network, a V-24 four-way communications block with the concentration station, with a local printer, with a remote terminal, and with a magnetic recording unit.

3. Energy counter measuring system according to the preceding claims, characterised in that the concentration station comprises a master processor which manages an assembly of eight V-24 type communication channels with programmable transmission speeds, as well as other channels, of the same type, for linking with printers and the centralized station and reserve channels; this master processor also controlling a communications channel via switched network and linking with a slave processor which manages the signals generated by a clock-calendar block, a keyboard and a visual display means, and an alarm printer block, and in that a modem unit is also incorporated for the conversion of the information signals and for the phonic or supraphonic band links.

FIG.1

FIG.2

0196408

FIG.3

3/3

0196408

FIG.4

FIG.5

**0196408**

Application number

# EUROPEAN SEARCH REPORT

EP 86 10 0686

## DOCUMENTS CONSIDERED TO BE RELEVANT

| Category | Citation of document with indication, where appropriate, of relevant passages | Relevant to claim | CLASSIFICATION OF THE APPLICATION (Int Cl.4) |
|---|---|---|---|
| Y | LANDIS & GYR MITTEILUNGEN, vol. 24, no. 3, 1977, pages 2-8; H. CEEGER "Programmierbare Apparate DATAGYR FAB... zur modernen Zählwert-Verarbeitung" <br> * page 2, right-hand column, paragraph 2 - page 4, left-hand column, paragraph 4; figure 1 * <br><br>--- | 1-3 | G 06 F 15/20 <br> G 01 R 21/00 |
| Y | CH-A- 607 472 (GENERAL ELECTRIC CO.) <br> * column 1, line 1 - column 2, line 55, figures 1, 3 * <br><br>--- | 1 | |
| Y | ELECTRONICS, 7th July 1977, New York, US; D. PHILLIPS et al.: "Slave microcomputer lightens main microprocessor load" <br> * pageS 109-110; figures , 2 * <br><br>--- | 1-3 | **TECHNICAL FIELDS SEARCHED (Int. Cl 4)** |
| A | US-A-3 842 249 (M.A. GEYER et al.) <br> * abstract, figures 1-3 * <br><br>----- | 1-3 | G 01 R 21/00 <br> G 06 F 13/00 <br> G 06 F 15/20 <br> G 06 F 15/56 <br> G 06 F 15/74 |

The present search report has been drawn up for all claims

| Place of search | Date of completion of the search | Examiner |
|---|---|---|
| BERLIN | 26-06-1986 | LEMMERICH J |

EPO Form 1503 03 82